# FASCICULE DE BREVET EUROPEEN

(11) **EP 3 245 653 B1**
(45) Date de publication et mention de la délivrance du brevet: **11.03.2020**
(21) Numéro de dépôt: 16702188.0
(22) Date de dépôt: 13.01.2016
(51) Int. Cl.: G11C 11/18, G11C 11/16

(54) **POINT MÉMOIRE MAGNÉTIQUE**
MAGNETSPEICHEREINSCHUB
MAGNETIC MEMORY SLOT

(30) Priorité: 14.01.2015 FR 1550273
(43) Date de publication de la demande: 22.11.2017
(73) Titulaire: Centre National de la Recherche Scientifique, 75794 Paris Cedex 16 (FR); Commissariat à l'Énergie Atomique et aux Énergies Alternatives, 75015 Paris (FR)
(72) Inventeur: GAUDIN, Gilles, 38700 Le Sappey en Chartreuse (FR); MIRON, Ioan Mihai, 38000 Grenoble (FR); BOULLE, Olivier, 38000 Grenoble (FR); CHENATTUKUZ HIYIL, Safeer, 38054 Grenoble (FR); NOZIERES, Jean-Pierre, 38700 Le Sappey en Chartreuse (FR)
(74) Mandataire: Lavoix
(86) Numéro de dépôt international: PCT/FR2016/050058
(87) Numéro de publication internationale: WO 2016/113503

(56) Documents cités:
- EP-A1- 2 278 589
- FR-A1- 2 914 482
- FR-A1- 2 924 851
- FR-A1- 2 963 152
- FR-A1- 2 976 113
- US-A1- 2014 010 004

## Description

La présente demande de brevet revendique la priorité de la demande de brevet français FR15/50273.

### Domaine

La présente invention concerne un point mémoire magnétique, et plus particulièrement un point mémoire magnétique de type à retournement induit par un courant.

### État de la technique

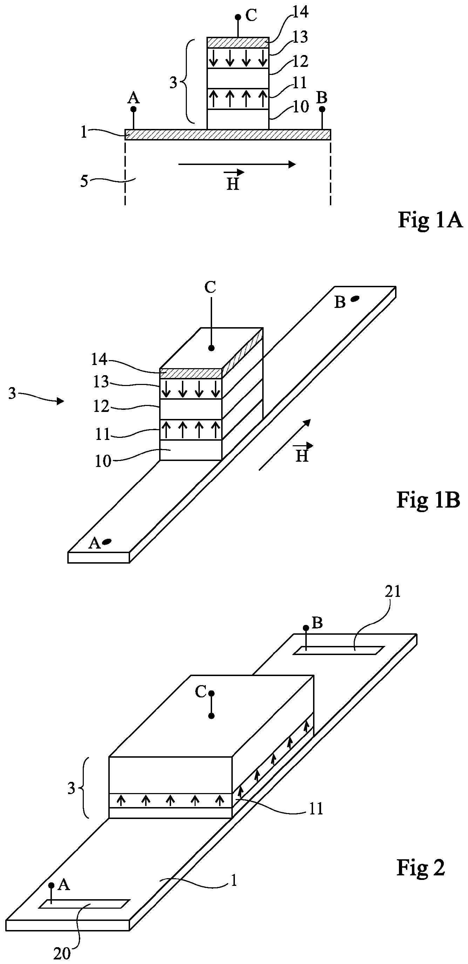

La demande de brevet français N° 2 963 152 décrit un point mémoire magnétique tel que représenté schématiquement en figures 1A, 1B et 2. Les figures 1A et 1B représentent respectivement une vue en coupe et une vue en perspective d'un point mémoire magnétique tel que décrit en relation avec les figures 1c-1f, 2a-2b et 3a-3d de la demande de brevet français N° 2 963 152. La figure 2 est une vue en perspective simplifiée de ce point mémoire.

Comme l'illustrent les figures 1A et 1B, ce point mémoire comprend, au-dessus d'une piste conductrice 1, un plot 3. Le plot 3 comprend un empilement de régions dont chacune est formée d'une portion d'une couche mince ou d'un empilement de plusieurs couches minces. La piste conductrice 1 est par exemple formée sur un substrat 5 constitué d'une plaquette de silicium revêtue d'une couche d'oxyde de silicium et est connectée entre des bornes A et B. L'empilement constituant le plot 3 comprend successivement à partir de la piste 1, une région 10 en un matériau conducteur non magnétique, une région 11 en un matériau magnétique, une région 12 en un matériau non magnétique, une région 13 en un matériau magnétique et une électrode 14. Le matériau de la couche 12 peut être conducteur ; c'est de préférence un matériau isolant suffisamment mince pour pouvoir être traversé par des électrons par effet tunnel. Il existe une différence structurelle entre les régions non magnétiques 10 et 12 de façon à avoir un système asymétrique dans une direction orthogonale au plan des couches. Cette différence peut résulter notamment d'une différence de matériau, d'épaisseur, ou de mode de croissance de ces couches.

Des listes de matériaux pouvant constituer les diverses couches sont données dans la demande de brevet susmentionnée. Les matériaux magnétiques des régions 11 et 13 sont formés dans des conditions telles qu'ils présentent une aimantation dirigée orthogonalement au plan des couches. Le matériau magnétique de la couche 13 est formé dans des conditions telles qu'il conserve une aimantation intangible (couche piégée). La couche d'électrode supérieure 14 est connectée à une borne C.

La programmation du point mémoire est effectuée en faisant circuler un courant entre les bornes A et B, tandis qu'un champ H orienté horizontalement (parallèlement au plan des couches et à la direction du courant entre les bornes A et B) est appliqué. Selon les sens relatifs du courant entre les bornes A et B et du vecteur de champ H, la couche 11 est programmée de sorte que son aimantation s'oriente vers le haut ou vers le bas.

Pour la lecture de ce point mémoire, une tension est appliquée entre la borne C et l'une ou l'autre des bornes A et B. Le courant résultant entre la borne C et l'une ou l'autre des bornes A et B prend des valeurs différentes selon le sens relatif des aimantations des couches 11 et 13 : valeur haute si les deux aimantations sont dans le même sens et valeur basse si les deux aimantations sont de sens opposés.

Une caractéristique importante du point mémoire décrit ci-dessus est que sa programmation se fait uniquement grâce à un courant circulant entre les bornes A et B et à un champ magnétique appliqué dans le plan des couches, parallèlement au courant. Aucun courant ne circule de la borne A ou B vers la borne C lors de la programmation. Ceci présente l'avantage de dissocier complètement les opérations de lecture et d'écriture du point mémoire.

De nombreuses variantes de réalisation sont possibles. Notamment, chaque couche décrite précédemment peut être constituée d'un empilement de couches de façon connue dans la technique pour acquérir les caractéristiques souhaitées.

La portion de couche 10 en un matériau conducteur non magnétique peut être omise, à condition que la piste 1 soit en un matériau non magnétique convenant à la croissance de la couche magnétique 11. La piste 1 peut alors présenter une surépaisseur sous le plot 3. Pour que le retournement de l'aimantation dans la couche 11 puisse se faire, il faut aussi que des couples de spin-orbite soient présents dans la couche magnétique. Pour ce faire, il faut par exemple que la couche en contact avec cette couche 11 (ou séparée d'elle par une couche séparatrice fine) soit constituée d'un matériau ou composée de matériaux à fort couplage spin-orbite. Une autre solution est, par exemple, que le contact entre la couche magnétique 11 et l'une ou l'autre des couches 10 et 12 crée ce couplage spin-orbite ; c'est ce qui peut par exemple arriver par hybridation de la couche magnétique 11 avec la couche 12 si celle-ci est constituée d'un isolant (voir "Spin-orbit coupling effect by minority interface resonance states in single-crystal magnetic tunnel junctions", Y. Lu et al. Physical Review B, Vol. 86, p.184420 (2012)).

On notera que le point mémoire des figures 1A et 1B peut être décomposé en deux éléments : un élément de mémorisation comprenant la piste 1 munie des bornes A et B et les portions de couches 10, 11 et 12, et un élément de lecture comprenant dans l'exemple donné ci-dessus les couches 13 et 14 et l'électrode C. Avec le même élément de mémorisation, divers modes de lecture pourraient être envisagés, par exemple une lecture optique.

La figure 2 reprend de façon simplifiée une vue en perspective du point mémoire de la figure 1B. Seule la piste 1 et l'empilement de couches ou plot 3 sont représentés, ainsi que les électrodes A et B connectées à des contacts 20 et 21.

Comme on l'a indiqué précédemment, ce point mémoire est programmable par l'application d'un courant entre les bornes A et B simultanément à l'application d'un champ magnétique ayant une composante non nulle selon la direction du courant. Des exemples de moyens de génération d'un champ magnétique sont donnés dans la demande de brevet susmentionnée. L'application d'un champ externe ou la réalisation de couches magnétiques spécifiques propres à créer le champ H pose des problèmes de réalisation pratique.

Des mémoires magnétiques sont décrites dans les demandes de brevet US 2014/010004 A1, FR 2 963 152 A1 EP 2 278 589 A1 et FR 2 976 113 A1.

### Résumé

Un objet de la présente demande est de prévoir un point mémoire magnétique du même type que celui décrit précédemment et dans lequel la programmation du point mémoire soit simplifiée.

Plus particulièrement, il est prévu ici que le point mémoire puisse être programmé par la simple application d'un courant en l'absence de champ magnétique.

Pour atteindre cet objet, il est prévu de remplacer le plot symétrique décrit dans la demande de brevet susmentionnée par un plot asymétrique. On constate alors que le point mémoire peut être programmé par la simple application d'un courant électrique dans la piste sur laquelle repose le plot mémoire, en l'absence de tout champ magnétique. Un mode de réalisation prévoit un point mémoire magnétique à retournement d'aimantation induit par un courant selon la revendication 1.

Un mode de réalisation prévoit un procédé de programmation d'un point mémoire magnétique à retournement d'aimantation induit par un courant selon la revendication indépendante 15.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B et 2 sont des représentations schématiques d'un point mémoire tel que décrit dans la demande de brevet français N° 2 963 152 ;
la figure 3 est une vue en perspective schématique d'un mode de réalisation d'un point mémoire ;
la figure 4 est une vue de dessus schématique du plot de la figure 3 ;
les figures 5A à 5J sont des vues de dessus schématiques de contours de divers modes de réalisation d'un point mémoire ;
la figure 6 est une vue en perspective schématique d'un autre mode de réalisation d'un point mémoire ; et
la figure 7 représente diverses courbes illustrant le fonctionnement du point mémoire de la figure 6.

Par souci de clarté, de mêmes éléments ont été désignés par de mêmes références aux différentes figures et, de plus, comme cela est habituel dans la représentation des composants intégrés, les diverses figures ne sont pas tracées à l'échelle.

### Description détaillée

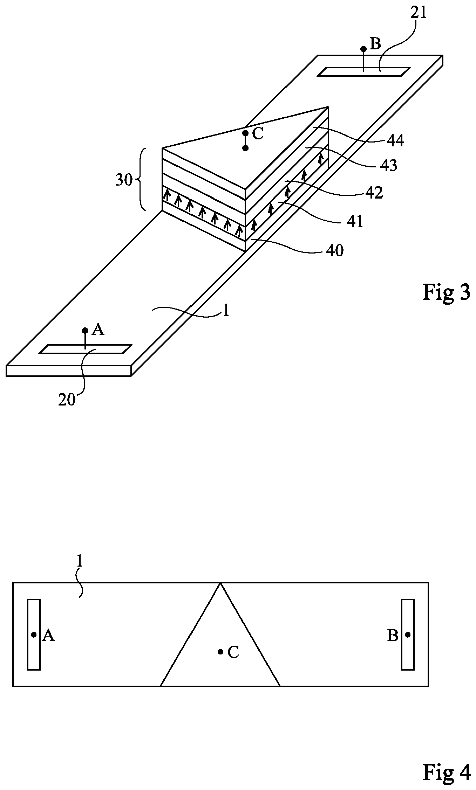

Comme le représente la figure 3, un mode de réalisation de point mémoire comprend un plot 30 disposé intégralement sur une piste conductrice 1 comprenant à ses extrémités des couches de connexion 20 et 21 reliées à des bornes A et B. Le plot 30 comprend le même empilement de couches que le plot 3 décrit précédemment. Ainsi le plot 30 comprend une région 40 en un matériau conducteur non magnétique, une région 41 en un matériau magnétique, une région 42 en un matériau non magnétique, cette région 42 présentant une différence par rapport à la région 40, une région 43 en un matériau magnétique et une électrode 44. Les mêmes variantes que celles décrites ci-dessus et dans la demande de brevet français susmentionnée s'appliquent.

Contrairement au plot 3 de la figure 2, le plot 30 a une configuration doublement asymétrique. D'une part, il est asymétrique par rapport à tout plan perpendiculaire au plan des couches et parallèle à l'axe central de la piste 1. D'autre part, il est asymétrique par rapport à son barycentre qui correspond au point C en figure 3. Comme on le voit mieux dans la vue de dessus de la figure 4, ce plot a par exemple une forme triangulaire. Un premier côté est parallèle au sens du courant de programmation (de A à B). Les deux autres côtés forment par exemple un angle de ± 20° à ± 70° et de préférence de ± 30° à ± 60° par rapport au premier côté. Du fait des défauts de photolithographie, les coins du triangle seront généralement arrondis. On pourra rechercher volontairement à obtenir une telle forme arrondie.

Il a été constaté qu'avec un plot ayant une telle forme doublement asymétrique (par rapport à un plan et par rapport à son barycentre) et disposé intégralement sur une piste, la seule application d'un courant de programmation entre les bornes A et B circulant dans la piste sous le plot et autour du plot permet de programmer la couche 41 de sorte que son aimantation soit dirigée vers le haut ou vers le bas selon le sens du courant de programmation. Ceci est effectué sans application d'un champ magnétique externe. Bien entendu, si une région 40 conductrice est prévue, sa résistivité et celle de la piste 1 sont choisies pour qu'une partie notable du courant entre les bornes A et B circule dans la région 40. On rappellera que si la piste 1 est en en matériau non magnétique, la région 40 pourra correspondre à la portion de piste sous-jacente au plot ou à une surépaisseur de cette région.

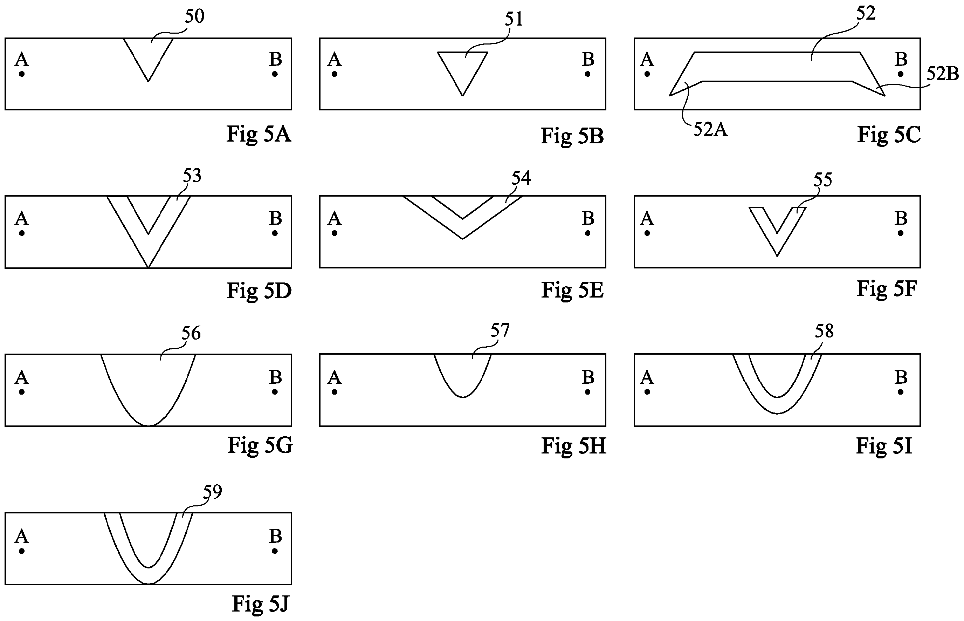

Les figures 5A à 5J représentent à titre d'exemple diverses formes de plots asymétriques qui peuvent être utilisées sur une piste 1. On considérera que ces figures font partie intégrante de la présente description.

Les plots 50 et 51 des figures 5A et 5B ont des formes de triangles comme le plot de la figure 4, mais avec des proportions et des centrages différents.

Le plot 52 de la figure 5C a une forme de croissant allongé dans le sens de la piste. En d'autres termes, le plot 52 a une forme trapézoïdale munie de deux protubérances effilées 52A et 52B aux extrémités de la base du trapèze. On considère aujourd'hui que la présence des protubérances effilées facilite le déclenchement du retournement de l'aimantation lors du passage du courant de programmation.

Les plots 53 à 55 des figures 5D à 5F ont des formes en chevron, la pointe du chevron étant tournée vers un côté de la piste 1, les chevrons ayant des dimensions et des positionnements divers par rapport à la largeur de la piste.

Les plots 56 à 59 des figures 5G à 5J sont des plots en forme de triangles et de chevrons à coins arrondis.

Les diverses formes décrites ci-dessus sont combinables et modifiables du moment que la règle de double asymétrie mentionnée ici est respectée. En particulier, toutes les formes envisagées peuvent être "arrondies" ou ne s'étendre que sur une partie de la largeur de la piste 1.

En ce qui concerne les matériaux et les épaisseurs des diverses régions du plot, on pourra se référer à la demande de brevet français susmentionnée.

A titre d'exemple :
- la région magnétique (41) peut comporter un alliage présentant une anisotropie magnétique perpendiculaire propre, à savoir, notamment FePt, FePd, CoPt ou bien encore un alliage de terre rare / métal de transition, notamment GdCo, TbFeCo,
- la région magnétique (41) peut comporter un métal ou un alliage présentant dans l'empilement une anisotropie magnétique perpendiculaire induite par les interfaces, notamment Co, Fe, CoFe, Ni, CoNi,
- au moins la région (40) ou la région (42) peut être conductrice, en un métal non magnétique, tel que Pt, W, Ir, Ru, Pd, Cu, Au, Bi, Hf ou en un alliage de ces métaux ou sous la forme d'un empilement de plusieurs couches de chacun de ces métaux,
- la région (42) peut être en un oxyde diélectrique tel que SiOx, AlOx, MgOx, TiOx, TaOx, HfOx ou en un nitrure diélectrique tel que SiNx, BNx, d'une épaisseur propre à autoriser un effet tunnel,
- l'épaisseur d'une des régions (40) et (42) peut être comprise entre 0,5 nm et 200 nm, plus particulièrement entre 0,5 nm et 100 nm, et préférentiellement inférieure à 3 nm,
- la région supérieure (42) peut être recouverte d'une couche de lecture (43) formée d'un matériau magnétique, ou d'un composé de matériaux magnétiques, ou de plusieurs couches de matériaux magnétiques et non magnétiques et d'une électrode de lecture (44), et
- l'épaisseur de la région magnétique peut être inférieure à 3 nm.

En vue de dessus, les dimensions latérales du plot peuvent être de l'ordre de 10 à 100 nm.

Les points mémoire décrits ci-dessus peuvent être assemblés en une matrice mémoire, comme cela est décrit dans la demande de brevet français susmentionnée.

### Mode de réalisation à forte stabilité thermique

Les points mémoire décrits précédemment ont des fonctionnements satisfaisants. Néanmoins, pour que l'intensité du courant nécessaire à la programmation ne soit pas excessive, il convient de prévoir des couches de mémorisation aussi minces que possible. On en arrive à réaliser des couches de mémorisation d'une épaisseur inférieure à 3 nanomètres, ayant même par exemple une épaisseur inférieure au nanomètre. Une telle réduction d'épaisseur, si elle favorise la réduction de l'intensité du courant de programmation, entraine un défaut de stabilité des points mémoire. En effet, des points mémoire comprenant une couche de mémorisation aussi mince, risquent de changer d'état accidentellement, notamment par suite de perturbations telles que l'agitation thermique ou des champs magnétiques parasites. Ainsi, ces points mémoire ont, en moyenne, une stabilité thermique limitée, ce qui conduit à prévoir de les reprogrammer périodiquement.

Pour pallier cet inconvénient il est prévu de coupler la région magnétique, généralement ferromagnétique, de mémorisation à une région d'un matériau antiferromagnétique.

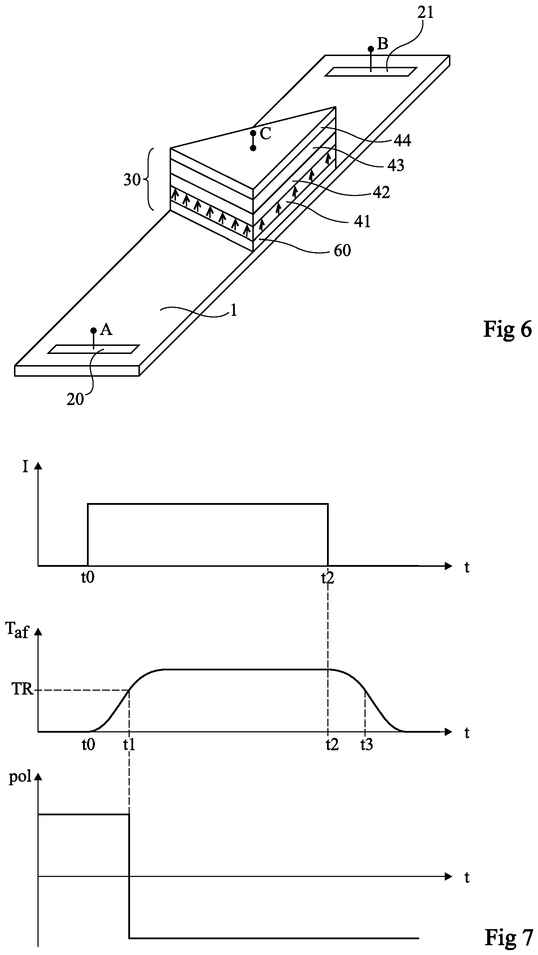

La figure 6 représente un mode de réalisation d'un point mémoire à stabilité thermique augmentée, correspondant au mode de réalisation de la figure 3. En figure 6, la couche conductrice non magnétique 40 de la figure 3 est remplacée par une couche conductrice 60 en un matériau antiferromagnétique. Ce matériau antiferromagnétique se couple par interaction d'échange avec le matériau magnétique, par exemple ferromagnétique, de la couche de mémorisation 41. Ceci permet de piéger l'aimantation de cette couche magnétique et d'assurer une stabilité thermique.

Cette structure est susceptible de diverses variantes. Notamment, sous la couche de matériau antiferromagnétique 60 peut être prévue une sous-couche tampon conductrice (non représentée), destinée notamment à permettre un dépôt satisfaisant de la couche de matériau antiferromagnétique 60. De plus, une couche mince d'un matériau conducteur non magnétique, par exemple du cuivre peut être disposée entre les régions ferromagnétique et antiferromagnétique pour réduire, si nécessaire, le couplage entre ces régions.

Comme l'illustrent les courbes de la figure 7, la programmation du point mémoire s'effectue de la façon suivante. A partir d'un instant t0, on envoie une impulsion de courant I entre les bornes A et B, ce courant ayant une direction propre à assurer le retournement de l'aimantation de la couche magnétique 41. Dans un premier temps, rien ne se produit en raison du couplage entre les couches magnétique 41 et antiferromagnétique 60. Toutefois, la température T_{af} du matériau antiferromagnétique augmente par effet Joule et l'organisation en aimantation de ce matériau se dégrade, d'où il résulte que le couplage entre les matériaux magnétique 41 et antiferromagnétique 60 diminue. A partir d'un instant t1, ce couplage devient suffisamment faible pour que de l'aimantation "pol" de la couche 41 s'inverse sous l'effet de la partie du courant I circulant dans les couches ferromagnétique et antiferromagnétique du plot. Une fois que l'impulsion de courant entre les bornes A et B cesse, à un instant t2, la température T_{af} du matériau antiferromagnétique diminue et celui-ci reprend, à un instant t3, un état organisé qui se recouple avec la polarisation modifiée de l'aimantation dans la couche de mémorisation 41 et assure sa stabilité. Afin d'éviter d'éventuelles erreurs d'écriture dues à l'agitation thermique au cours du refroidissement du point mémoire, le courant I pourra être diminué de façon graduelle et contrôlée afin de contrôler la température du plot et l'amplitude des couples responsables du retournement de l'aimantation de façon plus indépendante. Le courant I sera par exemple diminué graduellement sur un intervalle de temps inférieur à 1 µs, plus particulièrement inférieur à 100 ns et de préférence inférieur ou égal à 10 ns.

On choisira une couche de matériau antiferromagnétique d'une nature telle que la température TR pour laquelle la diminution du couplage d'échange avec la couche magnétique, qui permet à l'aimantation dans cette dernière d'être plus libre de se retourner, soit nettement supérieure aux températures d'utilisation prévues pour le fonctionnement du point mémoire ou de la mémoire dans laquelle ce point mémoire est incorporé. La température TR est par exemple de l'ordre de 140°C pour des écritures lentes et de l'ordre de 220 à 300°C pour des écritures rapides.

A titre d'exemple de matériaux antiferromagnétiques utilisables ici, on peut citer des alliages comme par exemple ceux à base de Mn tels que IrMn, FeMn, PtMn, ou des alliages de ces composés comme PtFeMn ou encore des matériaux obtenus par laminage de ces composés ou encore des oxydes tels que CoOx ou NiOx, le matériau magnétique, de préférence ferromagnétique, utilisé pour la couche de mémorisation étant alors un matériau tel que décrit précédemment pour la couche 41. De façon générale, la conductivité électrique du matériau antiferromagnétique doit être suffisante pour que du courant y passe pendant la phase d'écriture et tout matériau antiferromagnétique répondant à cette condition, se couplant par échange avec le matériau ferromagnétique et ayant une température de blocage comprise entre 120 et 450°C, pourra être utilisé.

Ainsi, le point mémoire décrit précédemment peut être stabilisé, même en prévoyant une couche magnétique très mince, d'une épaisseur inférieure à 3 nm et de préférence inférieure à 1 nm. La couche de matériau antiferromagnétique 60 aura une épaisseur comprise entre 1 et 200 nm, plus particulièrement entre 1 et 50 nm et de préférence inférieure à 10 nm. Cette épaisseur dépendra du matériau utilisé, par exemple de l'ordre de 10 nm pour du FeMn, et de l'ordre de 4 à 5 nm pour de l'IrMn. Le temps de retournement d'un tel point magnétique peut être très faible. Les impulsions de courant I représentées en figure 7 pourront, par exemple, avoir une durée inférieure à 15 nanosecondes.

## Revendications

1. Point mémoire magnétique de type à retournement d'aimantation induit par un courant comprenant un plot (30) constitué d'un empilement de régions en couches minces, comprenant :
- une première région (40 ; 60) en un matériau conducteur ;
- une deuxième région (41) en un matériau magnétique présentant une aimantation dans une direction perpendiculaire au plan principal du plot ;
- une troisième région (42) en un matériau non magnétique de caractéristiques différentes de celles de la première région,
ledit plot reposant sur une piste conductrice (1) adaptée à faire circuler un courant de programmation de sens choisi dans la piste conductrice,
ledit plot ayant une forme asymétrique, d'une part par rapport à tout plan perpendiculaire au plan des couches et parallèle à l'axe central de la piste, et d'autre part par rapport à son barycentre,
d'où il résulte que le sens de l'aimantation dans la deuxième région est programmable par le sens de circulation dudit courant de programmation, en l'absence de champ magnétique externe,
**caractérisé en ce que** le plot (30) repose intégralement sur la piste conductrice et a une forme triangulaire avec un premier côté parallèle au sens du courant de programmation et deux autres côtés faisant un angle de ± 20° à ± 70° par rapport au premier côté.

2. Point mémoire selon la revendication 1, dans lequel la première région (40) correspond à une portion de la piste (1) sous-jacente au plot ou à une surépaisseur de cette portion sous-jacente.

3. Point mémoire selon la revendication 1, dans lequel le plot a une forme triangulaire à coins arrondis.

4. Point mémoire selon l'une quelconque des revendications 1 à 3, dans lequel le plot ne s'étend que sur une partie de la largeur de la piste (1) .

5. Point mémoire selon l'une quelconque des revendications 1 à 4, dans lequel la deuxième région (41) comporte un alliage présentant une anisotropie magnétique perpendiculaire propre, à savoir, notamment FePt, FePd, CoPt ou bien encore un alliage de terre rare / métal de transition, notamment GdCo, TbFeCo .

6. Point mémoire selon l'une quelconque des revendications 1 à 4, dans lequel la deuxième région (41) comporte un métal ou un alliage présentant dans l'empilement une anisotropie magnétique perpendiculaire induite par les interfaces, notamment Co, Fe, CoFe, Ni, CoNi.

7. Point mémoire selon l'une quelconque des revendications 1 à 6, dans lequel au moins la première région (40) ou la troisième région (42) est conductrice et est en un métal non magnétique, tel que Pt, W, Ir, Ru, Pd, Cu, Au, Bi, Hf ou en un alliage de ces métaux, ou est formée d'un empilement de plusieurs couches de chacun de ces métaux.

8. Point mémoire selon l'une quelconque des revendications 1 à 6, dans lequel la troisième région (42) est en un oxyde diélectrique tel que SiOx, AIOx, MgOx, TiOx, TaOx, HfOx ou en un nitrure diélectrique tel que SiNx, BNx.

9. Point mémoire selon l'une quelconque des revendications 1 à 8, dans lequel l'épaisseur des première (40) et troisième (42) régions est comprise entre 0,5 et 200 nm, plus particulièrement entre 0,5 et 100 nm, et préférentiellement inférieure à 3 nm.

10. Point mémoire selon l'une quelconque des revendications 1 à 9, dans lequel la troisième région (42) est recouverte d'une couche de lecture (43) en matériau magnétique et d'une électrode de lecture (44) .

11. Point mémoire selon l'une quelconque des revendications 1 à 10, dans lequel l'épaisseur de la deuxième région (41) est inférieure à 3 nm.

12. Point mémoire selon l'une quelconque des revendications 1, 3 à 6, 10 et 11, dans lequel la première région (60) est en un matériau antiferromagnétique conducteur.

13. Point mémoire selon la revendication 12, comprenant une couche tampon conductrice entre la première région (60) et la piste (1) .

14. Point mémoire selon la revendication 12 ou 13, dans lequel l'épaisseur de la première région (60) en un matériau antiferromagnétique est comprise entre 1 et 200 nm, et de préférence inférieure à 10 nm.

15. Procédé de programmation d'un point mémoire selon l'une quelconque des revendications 12 à 14, comprenant l'étape consistant à faire passer dans la piste, et par voie de conséquence dans la première région (60) de matériau antiferromagnétique, un courant d'intensité propre à chauffer ce matériau de façon à désorganiser son aimantation, le sens de ce courant étant choisi pour programmer l'aimantation du matériau de la deuxième région (41) selon une orientation désirée.

## Patentansprüche

1. Magnetischer Speicherpunkt mit von einem Strom induzierten Magnetisierungsumkehr, der einen aus einem Stapel von Dünnschichtbereichen gebildeten Klotz (30) aufweist, umfassend:
- einen ersten Bereich (40; 60) aus einem leitenden Material;
- einen zweiten Bereich (41) aus einem magnetischen Material, das eine Magnetisierung in einer Richtung senkrecht zur Hauptebene des Klotzes aufweist;
- einen dritten Bereich (42) aus einem nicht magnetischen Material mit unterschiedlichen Eigenschaften zu denen des ersten Bereichs, wobei der Klotz auf einer Leiterbahn (1) ruht, die angepasst ist, einen Programmierstrom mit gewählter Richtung in der Leiterbahn fließen zu lassen,
der Klotz eine asymmetrische Form aufweist, einerseits in Bezug auf jede Ebene senkrecht zur Ebene der Schichten und parallel zur Mittelachse der Bahn und andererseits in Bezug auf seinen Schwerpunkt, wodurch resultiert, dass die Magnetisierungsrichtung in dem zweiten Bereich durch die Strömungsrichtung des Programmierstroms in Abwesenheit eines äußeren Magnetfeldes programmierbar ist,
**dadurch gekennzeichnet, dass** der Klotz (30) integral auf der Leiterbahn ruht und eine dreieckige Form mit einer ersten Seitenfläche parallel zur Richtung des Programmierstroms und zwei anderen Seitenflächen, die einen Winkel von ± 20° bis ± 70° in Bezug auf die erste Seitenfläche bilden.

2. Speicherpunkt nach Anspruch 1, bei dem der erste Bereich (40) einem Teil der Bahn (1) unterhalb des Klotzes oder einer Erhebung dieses darunterliegenden Teils entspricht.

3. Speicherpunkt nach Anspruch 1, bei dem der Klotz eine dreieckige Form mit abgerundeten Ecken aufweist.

4. Speicherpunkt nach einem beliebigen der Ansprüche 1 bis 3, bei dem der Klotz sich nur über einen Teil der Breite der Bahn (1) erstreckt.

5. Speicherpunkt nach einem beliebigen der Ansprüche 1 bis 4, bei dem der zweite Bereich (41) eine Legierung aufweist, die eine eigene senkrechte magnetische Anisotropie aufweist, insbesondere FePt, FePd, CoPt oder auch eine Legierung von seltenen Erden/Übergangsmetall, insbesondere GdCo, TbFeO.

6. Speicherpunkt nach einem beliebigen der Ansprüche 1 bis 4, bei dem der zweite Bereich (41) ein Metall oder eine Legierung aufweist, das bzw. die in dem Stapel eine senkrechte magnetische Anisotropie aufweist, die durch die Grenzflächen, insbesondere Co, Fe, CoFe, Ni, CoNi induziert wird.

7. Speicherpunkt nach einem beliebigen der Ansprüche 1 bis 6, bei dem mindestens der erste Bereich (40) oder der dritte Bereich (42) leitend ist und aus einem nicht magnetischen Metall besteht, wie Pt, W, Ir, Ru, Pd, Cu, Au, Bi, Hf oder aus einer Legierung dieser Metalle oder aus einem Stapel von mehreren Schichten jedes dieser Metalle gebildet ist.

8. Speicherpunkt nach einem beliebigen der Ansprüche 1 bis 6, bei dem der dritte Bereich (42) aus einem dielektrischen Oxid, wie SiOx, AlOx, MgOx, TiOx, TaOx, HfOx oder aus einem dielektrischen Nitrid, wie SiNx, BNx besteht.

9. Speicherpunkt nach einem beliebigen der Ansprüche 1 bis 8, bei dem die Dicke des ersten (40) und dritten (42) Bereichs zwischen 0,5 und 200 nm, insbesondere zwischen 0,5 und 100 nm liegt und vorzugsweise kleiner als 3 nm ist.

10. Speicherpunkt nach einem beliebigen der Ansprüche 1 bis 9, bei dem der dritte Bereich (42) mit einer Ausleseschicht (43) aus einem magnetischen Material und einer Ausleseelektrode (44) bedeckt ist.

11. Speicherpunkt nach einem beliebigen der Ansprüche 1 bis 10, bei dem die Dicke des zweiten Bereichs (41) kleiner als 3 nm ist.

12. Speicherpunkt nach einem beliebigen der Ansprüche 1, 3 bis 6, 10 und 11, bei dem der erste Bereich (60) aus einem antiferromagnetisch leitenden Material besteht.

13. Speicherpunkt nach Anspruch 12, eine leitende Pufferschicht zwischen dem ersten Bereich (60) und der Bahn (1) umfassend.

14. Speicherpunkt nach Anspruch 12 oder 13, bei dem die Dicke des ersten Bereichs (60) aus einem antiferromagnetischen Material zwischen 1 und 200 nm liegt, vorzugsweise kleiner als 10 nm ist.

15. Verfahren zum Programmieren eines Speicherpunktes nach einem beliebigen der Ansprüche 12 bis 14, einen Schritt umfassend, der darin besteht, in der Bahn und folglich in dem ersten Bereich (60) des antiferromagnetischen Materials einen Strom fließen zu lassen, der eine zum Aufheizen dieses Materials geeignete Intensität aufweist, um seine Magnetisierung zu desorganisieren, wobei die Richtung dieses Stroms ausgewählt ist, um die Magnetisierung des Materials des zweiten Bereichs (41) gemäß einer gewünschten Orientierung zu programmieren.

## Claims

1. Magnetic memory cell of the type with current-induced magnetisation reversal, comprising a contact (30) constituted by a stack of regions of thin layers, comprising:
- a first region (40; 60) made of a conductive material;
- a second region (41) made of a magnetic material having magnetisation in a direction perpendicular to the main plane of the contact;
- a third region (42) made of a non-magnetic material having characteristics which are different from those of the first region,
said contact resting on a conductive track (1) which is adapted to cause a programming current of a chosen direction to flow in the conductive track,
said contact having an asymmetrical shape, on the one hand relative to any plane perpendicular to the plane of the layers and parallel to the central axis of the track, and on the other hand relative to its centre of mass,
with the result that the direction of magnetisation in the second region is programmable by the direction of flow of said programming current, in the absence of an external magnetic field,
**characterised in that** the contact (30) rests entirely on the conductive track and has a triangular shape with a first side parallel to the direction of the programming current and two other sides which form an angle of from ± 20° to ± 70° relative to the first side.

2. Memory cell according to claim 1, wherein the first region (40) corresponds to a portion of the track (1) underlying the contact or to an overthickness of that underlying portion.

3. Memory cell according to claim 1, wherein the contact has a triangular shape with rounded corners.

4. Memory cell according to any one of claims 1 to 3, wherein the contact extends over only a portion of the width of the track (1).

5. Memory cell according to any one of claims 1 to 4, wherein the second region (41) comprises an alloy having inherent perpendicular magnetic anisotropy, namely especially FePt, FePd, CoPt, or alternatively a rare earth/transition metal alloy, especially GdCo, TbFeCo.

6. Memory cell according to any one of claims 1 to 4, wherein the second region (41) comprises a metal or an alloy having in the stack perpendicular magnetic anisotropy induced by the interfaces, especially Co, Fe, CoFe, Ni, CoNi.

7. Memory cell according to any one of claims 1 to 6, wherein at least the first region (40) or the third region (42) is conductive and is made of a non-magnetic metal, such as Pt, W, Ir, Ru, Pd, Cu, Au, Bi, Hf or of an alloy of those metals, or is formed of a stack of a plurality of layers of each of those metals.

8. Memory cell according to any one of claims 1 to 6, wherein the third region (42) is made of a dielectric oxide such as SiOx, AlOx, MgOx, TiOx, TaOx, HfOx or of a dielectric nitride such as SiNx, BNx.

9. Memory cell according to any one of claims 1 to 8, wherein the thickness of the first (40) and third (42) regions is between 0.5 and 200 nm, more particularly between 0.5 and 100 nm, and preferably less than 3 nm.

10. Memory cell according to any one of claims 1 to 9, wherein the third region (42) is covered with a readout layer (43) made of magnetic material and with a readout electrode (44).

11. Memory cell according to any one of claims 1 to 10, wherein the thickness of the second region (41) is less than 3 nm.

12. Memory cell according to any one of claims 1, 3 to 6, 10 and 11, wherein the first region (60) is made of a conductive antiferromagnetic material.

13. Memory cell according to claim 12, comprising a conductive buffer layer between the first region (60) and the track (1).

14. Memory cell according to claim 12 or 13, wherein the thickness of the first region (60) made of an antiferromagnetic material is between 1 and 200 nm and preferably less than 10 nm.

15. Method for programming a memory cell according to any one of claims 12 to 14, comprising the step which consists in passing into the track, and consequently into the first region (60) of antiferromagnetic material, a current having an intensity capable of heating the material so as to disrupt the magnetisation thereof, the direction of the current being chosen to programme the magnetisation of the material of the second region (41) according to a desired orientation.
